# EUROPEAN PATENT SPECIFICATION

(11) **EP 4 068 931 B1**
(45) Date of publication and mention of the grant of the patent: **01.05.2024**
(21) Application number: 21306188.0
(22) Date of filing: 31.08.2021
(51) Int. Cl.: H05K 7/20

(54) **RACK SYSTEM FOR HOUSING AT LEAST ONE IMMERSION CASE**
RACKSYSTEM ZUR AUFNAHME MINDESTENS EINES TAUCHGEHÄUSES
SYSTÈME DE CRÉMAILLÈRE POUR ACCUEILLIR AU MOINS UN BOÎTIER D'IMMERSION

(30) Priority: 01.04.2021 EP 21305427; 30.08.2021 EP 21306170; 30.08.2021 EP 21306171
(43) Date of publication of application: 05.10.2022
(73) Proprietor: OVH, 59100 Roubaix (FR)
(72) Inventor: BAUCHART, Grégory Francis Louis, 59150 Wattrelos (FR); MENEBOO, Alexandre Alain Jean-Pierre, 62440 Harnes (FR); CHEHADE, Ali, 59283 Moncheaux (FR)
(74) Representative: BCF Global

(56) References cited:
- WO-A1-2020/170079
- JP-A- H 043 451
- US-B1- 10 667 434
- US-B2- 10 149 408
- US-B2- 10 638 641
- US-B2- 10 932 390

## Description

### REFERENCE TO RELATED APPLICATION

The present application claims priority to European Patent Application EP21305427, which was filed April, 1st 2021.

### TECHNICAL FIELD

The present technology relates to rack-mounted, liquid-cooled electronic equipment and, in particular, collapsible reservoirs for storing fluids in rack systems.

### BACKGROUND

Large computing facilities endeavour to keep up with the market demand for increased processing resources. Such facilities may, therefore, implement a large number of rack systems configured to support thousands or even tens of thousands of electronic processing assemblies to accommodate the market demand.

It will be appreciated that such a multitude of racked electronic processing assemblies consume large amounts of power and, in turn, generate substantial amounts of heat that needs to be controlled in order to ensure proper processing performance. Various heat mitigation measures, such as, for example, liquid-cooling techniques, have been implemented to cool the racked electronic processing assemblies to acceptable temperature levels. In some instances, the liquid-cooling techniques involve submerging portions of the racked electronic processing assemblies in a liquid.

During maintenance operations of the racked electronic processing assemblies, said racked electronic processing assemblies can undergo racking and de-racking operations. These operations can result in liquid spillage, and can be difficult to perform due to a weight of the racked electronic processing assemblies. Furthermore, accessing portions of the racked electronic processing assemblies can be problematic as they are submerged in the liquid.

JP H043451A discloses a semiconductor cooling device to shorten time required for sealing a cooling medium liquid into a chamber and for extracting its liquid from the chamber by coupling the chamber to a constant-pressure appliance with a piping system and then, controlling pressure in the chamber so that it is almost equal to atmospheric pressure. When cooling capacity of a condenser and a liquid cooler is relatively insufficient in comparison with the heating value of each LSI chip, a temperature in an IP mainframe rises and a working point moves in the direction which improves the capacity of the cooler. When the temperature in the IP mainframe is about to rise, pressure in the IP mainframe is about to rise as well. The bellows of a constant-pressure appliance acts on this device so that pressure in the bellows balances with pressure which is obtained by adding the force of a spring in the bellows to pressure that is applied to the outside of the bellows. Yet, in the case where the bellows is equipped with the spring having only a slight spring force, once pressure in the mainframe is about to rise, the bellows expands and then, the volume inside the bellows increases. Such a state of the bellows lowers and makes it almost equal to atmospheric pressure.

US 10,932,390 B2 relates to an immersion tank including a tank main body configured to store a coolant, at least one first air bag that is provided in the tank main body, that is coupled to a bottom portion of the tank main body, that is able to be inflated toward an upper portion of the tank main body, and that is able to be deflated, from an inflated state thereof, toward the bottom portion, and a guide member that is provided outside the at least one first air bag in the tank main body and that is configured to guide the at least one first air bag during the inflation and the deflation of the at least one first air bag.

WO 2020/170079 A1 relates to a thermal management system including a housing having an interior space; a heat-generating component disposed within the interior space; and a working fluid comprising a halogenated material disposed within the interior space such that the heat-generating component contacts a liquid phase of the working fluid. The system further includes a bellows assembly disposed with the interior space, the bellows assembly comprising a first bellows and a second bellows. The first bellows is in fluid communication with the interior space and the second bellows is in fluid communication with an environment external to the housing. The first and second bellows are mechanically coupled such that expansion of the first bellows causes contraction of the second bellows, and contraction of the first bellows causes expansion of the second bellows.

US 10,149,408 B2 relates to a liquid immersion bath for an electronic device including: a bath body that is capable of housing the electronic device, is coupled to a circulation path through which a liquid coolant which cools the electronic device immersed in the liquid coolant circulates, and includes a gas phase portion corresponding to a space free from the liquid coolant; and a container that is disposed in the gas phase portion and has a volume which changes in accordance with a pressure of the gas phase portion, wherein an inside of the container is coupled to an outside of the bath body.

US 10,638,641 B2 discloses a system including a cooling rack for servers, a first enclosure, and a second enclosure. The first enclosure can be coupled to the cooling rack for servers and houses electronics. The second enclosure can be coupled to the cooling rack for servers beneath the first enclosure with a minimal sliding clearance in between the two enclosures. The second enclosure also holds an electronics cartridge and connects to the cooling rack for servers via a slide that enables the second enclosure to slide out from under the first enclosure so that the electronics cartridge can be removed from a top of the enclosure. Further, the second enclosure may contain a fluid to immerse components and absorb heat from the electronics cartridge.

US 10,667,434 B1 discloses a liquid immersion cooling device including a mounting frame, a liquid reservoir mounted to the mounting frame, and a cold source distributor mounted on an outer side of the mounting frame. The liquid reservoir is configured to immerse a server in an insulating coolant. The liquid reservoir is movably mounted to the mounting frame. The cold source distributor comprises a telescopic cold source tube and a telescopic heat return tube. An output end of the cold source tube and an output end of the heat return tube are coupled to the liquid reservoir. When the liquid reservoir is pulled out of the mounting frame, the cold source tube and the heat return tube are extended by the liquid reservoir to a predetermined length. When the liquid reservoir is pushed into the mounting frame, the cold source tube and the heat return tube are retracted.

### SUMMARY

It is an object of the present technology to ameliorate at least some of the inconveniences present in the prior art.

According to one aspect of the present technology, there is provided a rack system (50) for housing at least one rack-mounted immersion case (54). The rack system (50) includes a rack frame (52) and at least one collapsible reservoir (58). The rack frame (52) is configured to allow slidable racking and slidable de-racking operations of the at least one rack-mounted immersion case (54) within the rack system (50). The at least one collapsible reservoir (58) is connected to the at least one rack-mounted immersion case (54). The at least one collapsible reservoir (58) is configured to store a liquid.

The at least one collapsible reservoir (58) has a first portion (100) connected to the at least one rack-mounted immersion case (54) vertically below an expected level of fluid in the at least one rack-mounted immersion case (54) when the at least one rack-mounted immersion case (54) is in the de-racked position, and a second portion (102) fixedly connected to the rack frame (52). The at least one collapsible reservoir (58) is configured to collapse along a racked spaced in response to a racking operation, and to expand along a de-racked space in response to a de-racking operation.

The racked and de-racked spaces are defined between a backplane (70) of the at least one rack-mounted immersion case (54) and a backplane (62) of the rack frame (52), in which the de-racked space is larger than the racked space.

In some embodiments, the first portion (100) is fixedly connected to the backplane (70) of the at least one rack-mounted immersion case (54), and the second portion (102) is fixedly connected to the backplane (62) of the rack frame (52).

In some embodiments, the at least one rack-mounted immersion case (54) contains a liquid, the at least one collapsible reservoir (58) is configured to expand to allow some of the liquid to flow from the at least one rack-mounted immersion case (54) to the at least one collapsible reservoir (58) in response to de-racking the at least one rack-mounted immersion case.

In some embodiments, the at least one collapsible reservoir (58) is configured to collapse and allow some of the liquid to flow from the at least one collapsible reservoir (58) to the at least one rack-mounted immersion case (54) in response to racking the at least one rack-mounted immersion case (54).

In some embodiments, the at least one collapsible reservoir (58) includes bellows (90).

In some embodiments, the at least one collapsible reservoir (58) is configured to collapse linearly.

In some embodiments, the at least one collapsible reservoir (58) is made from plastic.

In some embodiments, the liquid is a dielectric immersion cooling liquid.

In some embodiments, the rack system (50) includes at least one articulating scissor structure (80) and an opening (64) within the rack frame (52). The opening (64) is configured to accommodate at least one cable/tube bundle (56). The at least one cable/tube bundle (56) services the at least one rack-mounted immersion case (54) within the rack system (52). The at least one articulating scissor structure (80) includes a first arm (82), a second arm (84) and a joining portion (86). The first arm (82) is detachably connected to a contact point (83) on the backplane (70) of the at least one rack-mounted immersion case (54). The second arm (84) is detachably connected to a contact point (85) on the backplane (62) of the rack frame (52). The joining portion (86) is connected the first and second arms (82, 84). The at least one articulating scissor structure (80) is configured to guide the at least one cable/tube bundle (56) along the racked space and the de-racked space. The at least one articulating scissor structure (80) is configured to laterally extend and guide the at least one cable/tube bundle (56) across the de-racked space during the de-racking operation of the at least one rack-mounted immersion case (54). The at least one articulating scissor structure (80) is configured to laterally contract and guide the cable/tube bundle (56) within the racked space during the racking operation of the at least one rack-mounted immersion case (54).

In some embodiments, the at least one articulating scissor structure (80) is configured to engage the at least one collapsible reservoir (58) to induce collapse of the collapsible reservoir (58) during the de-racking operation of the at least one rack-mounted immersion case (54).

In some embodiments, the at least one rack-mounted immersion case (54) includes a plurality of rack-mounted immersion cases (54).

In some embodiments, the at least one collapsible reservoir (58) includes a plurality of collapsible reservoirs (58).

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

It must be noted that, as used in this specification and the appended claims, the singular form "a", "an" and "the" include plural referents unless the context clearly dictates otherwise.

As used herein, the term "and/or" is to be taken as specific disclosure of each of the two specified features or components with or without the other. For example "A and/or B" is to be taken as specific disclosure of each of (i) A, (ii) B and (iii) A and B, just as if each is set out individually herein.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Aspects and advantages of implementations of the present technology will become apparent from the following description, the accompanying drawings, and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1A is a perspective view of rack system having a rack-mounted immersion case in a racked position connected to a collapsible reservoir in accordance with an embodiment of the present technology;
Figure 1B is a cross-sectional view of the rack system of Figure 1A taken across the plane 1B-1B of Figure 1A;
Figure 2A is a perspective view of the rack system of Figure 1A with the rack-mounted immersion case in a de-racked position;
Figure 2B is a cross-sectional view of the rack system of Figure 2A taken across the plane 2B-2B of Figure 2A;
Figure 3A is a left side elevation view of a rack system having a rack-mounted immersion case in a racked position connected to a collapsible reservoir in accordance to an alternate embodiment of the present technology; and
Figure 3B is a left side elevation view of the rack system of Figure 3A with the rack-mounted immersion case in de-racked position.

It should be noted that the various Figures are not to scale.

### DETAILED DESCRIPTION

The present disclosure is not limited in its application to the details of construction and the arrangement of components set forth in the following description or illustrated in the drawings. The disclosure is capable of other embodiments and of being practiced or of being carried out in various ways. Also, the phraseology and terminology used herein is for the purpose of description and should not be regarded as limiting. The use of "including", "comprising", or "having", "containing", "involving" and variations thereof herein, is meant to encompass the items listed thereafter as well as, optionally, additional items. In the following description, the same numerical references refer to similar elements.

The present technology will be described with reference to a rack system 50 including a rack frame 52, a plurality of rack-mounted immersion cases 54 (only one immersion case 54 is shown in accompanying Figures) and a plurality of collapsible reservoirs 58 (only one collapsible reservoir 58 is shown in accompanying Figures).

The rack frame 52, which is configured to house and to slidably accommodate racking and de-racking operations of the rack-mounted immersion cases 54, defines a front opening 60 which, in part, enables the racking and de-racking operations. The rack frame 52 has a backplane 62 that defines an opening 64 configured to accommodate a plurality of cable/tube bundles 56 (only one cable/tube bundle 56 shown in accompanying Figures) therethrough. In some embodiments, there could be two or more openings 64 configured to receive two or more cable/tube bundles 56 therethrough. The rack frame 52 has a single shelf that is configured to receive, for example and without limitation, sixteen rack-mounted immersion cases 54 therein. It is contemplated that in other embodiments, the shelf could be configured to receive more or less than sixteen rack-mounted immersion cases 54 therein. For instance, in some embodiments, the shelf could be configured to receive only one rack-mounted immersion cases 54. It is also contemplated that in other embodiments, the rack frame 52 could have two or more vertical shelves.

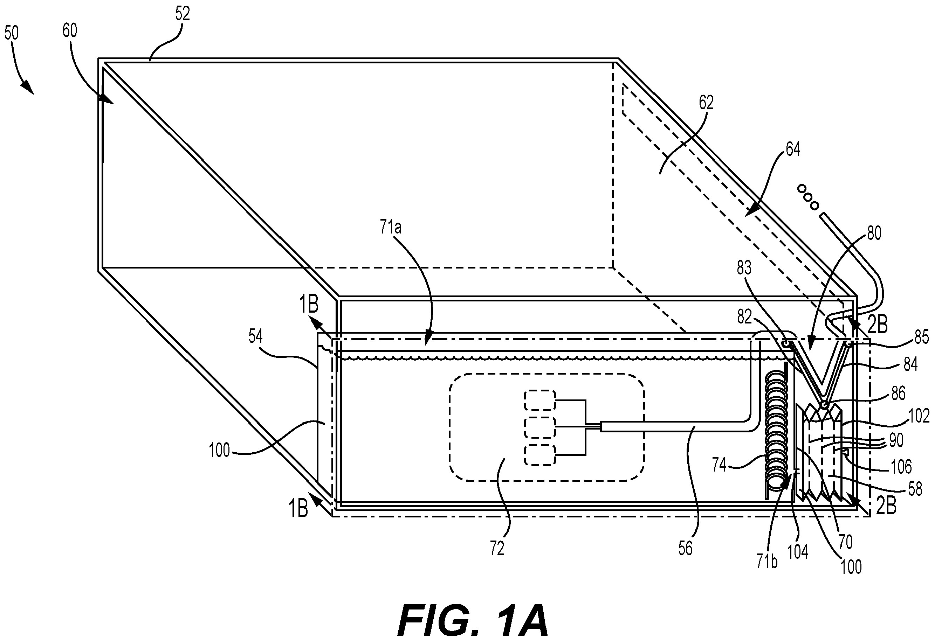

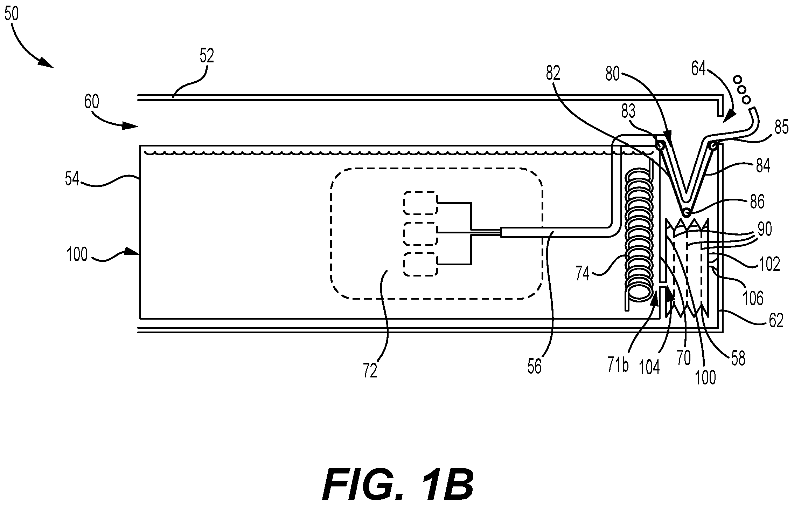

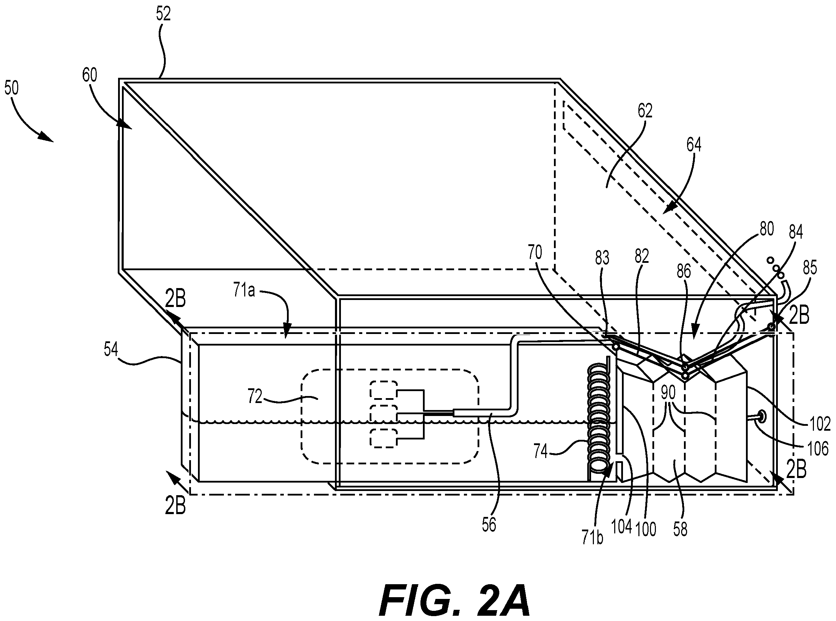

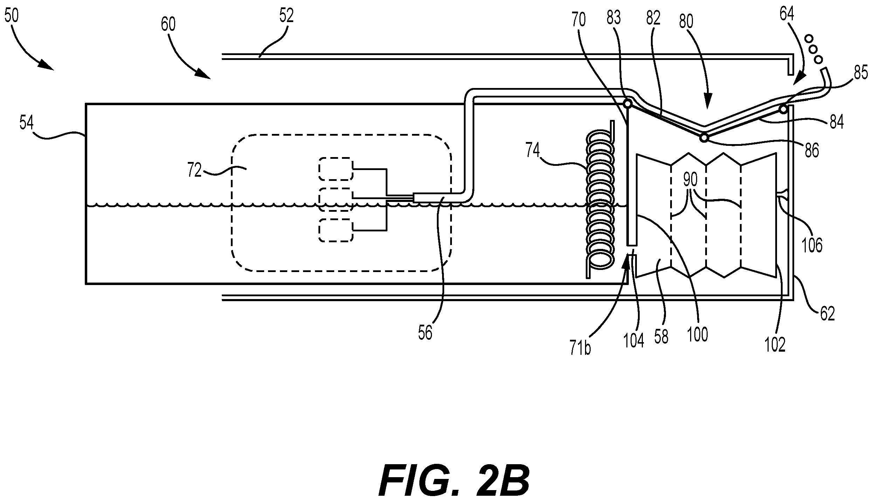

The rack-mounted immersion cases 54 are analogous to book sleeves. As mentioned above, the rack-mounted immersion cases 54 are configured to be racked and de-racked. When the rack-mounted immersion cases 54 are racked (shown in Figures 1A and 1B), a racked space is defined between a backplane 70 of the immersion case 54 and the backplane 62 of the rack frame 52. When the rack-mounted immersion cases 54 are de-racked (shown in Figures 2A and 2B), a de-racked space is defined between the backplane 70 of the immersion case 70 and the backplane 62 of the rack frame 52. The de-racked space is larger than the racked space.

As the rack-mounted immersion cases 54 are all constructed in similar fashion, and are configured to by similarly racked and de-racked, only one will be described in detail. The rack-mounted immersion case 54 is configured to receive an electronic device 72 and a serpentine convection coil 74 therein through an upper aperture 71a defined in the rack-mounted immersion case 54. The electronic device 72 may for example comprise a server, a hard disk drive, a power supply, and the like. It is contemplated that in some embodiments, the serpentine convection coil 74 could be another heat exchanger. In some embodiments, the rack-mounted immersion case 54 could be configured to receive two or more electronic devices 72 and/or two or more serpentine convection coils 74 therein. The rack-mounted immersion case 54 also defines a rear aperture 71b, which as will be described below, is configured to fluidly connect the rack-mounted immersion case 54 to the collapsible reservoir 58. As will also be described below, the rack-mounted immersion case 54 is configured to be filled with a dielectric immersion cooling liquid which can aid in cooling the electronic device 72.

The rack system 50 also includes the plurality of the cable/tube bundles 56, where each one of the cable/tube bundles 56 services one rack-mounted immersion case 54 by carrying hot and/or cold fluid and/or communication signals and/or electrical current in and/or out the rack-mounted immersion case 54. In some embodiments, the fluid carried by the cable/tube bundles 56 is water. Thus, each of the cable/tube bundles 56 is operatively connected to one of the rack-mounted immersion cases 54.

The rack system 50 also includes a plurality of articulating scissor structures 80 (only one articulating scissor structure 80 shown in accompanying Figures). Each one of the articulating scissor structures 80 is detachably connected to one of the rack-mounted immersion cases 54. Thus, the rack system 50 includes as many articulating scissor structures 80 as rack-mounted immersion cases 54. In some embodiments, the number of articulating scissor structures 80 could be different from the number of rack-mounted immersion case 54. It is also contemplated that in some embodiments, the articulating scissor structures 80 could be omitted from the rack system 50.

The articulating scissor structure 80 has an arm 82, an arm 84 and a joining portion 86 that connects the arms 82, 84. The arm 82 is detachably connected to a contact point 83 on the backplane 70 of the rack-mounted immersion case 54, whereas the arm 84 is detachably connected to a contact point 85 on the backplane 62 of the rack frame 52. In some embodiments, the arms 82, 84 could include a hook, a catch, a clasp, a latch, a clip or a grommet to connect to the backplanes 62, 70. As will be described in greater detail below, the articulating scissor structure 80 is configured to laterally extend and contract to guide one of the cable/tube bundles 56 along the rack and de-racked spaces. Although the articulating scissor structure 80 is shown in the Figures as being positioned above the collapsible reservoir 58, positioning the articulating scissor structure 80 on a lateral side of the collapsible reservoir 58 is also contemplated.

The rack system 50 also includes the plurality of collapsible reservoirs 58, where each one of the collapsible reservoirs 58 is fluidly connected to one of the rack-mounted immersion cases 54. Thus, the rack system 50 may include as many collapsible reservoirs 58 as rack-mounted immersion cases 54. In some embodiments, the number of collapsible reservoirs 58 could be different from the number of rack-mounted immersion case 54. For instance, in some embodiments, one collapsible reservoir 58 could be fluidly connected to more than one rack-mounted immersion case 54.

The collapsible reservoir 58, which is configured to store a fluid therein, namely the dielectric immersion cooling liquid, has a front portion 100 and a rear portion 102. At the front portion 100, the collapsible reservoir 58 has a connecting part 104 that is configured to be received in or otherwise fluidly connected to the rear aperture 71b of the rack-mounted immersion case 54, thereby fluidly connecting the collapsible reservoir 58 to rack-mounted immersion case 54. In some embodiments, the front portion 100 could be configured to receive a connecting part projecting from the rack-mounted immersion case 54. In other embodiments, the connecting part 104 could be elsewhere on the collapsible reservoir 58, such as for instance at the rear portion 102. In the present embodiment, the front portion 100 is fixedly connected to the rack-mounted immersion case 54 by the connecting part 104. It is contemplated that in some embodiments, the collapsible reservoir 58 could be fixedly connected to the rack-mounted immersion case 54 by an additional connector such as a hook, a catch, a clasp, a latch, a clip or a grommet. The rear portion 102 is fixedly connected to the backplane 62 of the rack frame 52 by a hook 106. It is contemplated that in other embodiments, the hook 106 could be another connector such as a catch, a clasp, a latch, a clip or a grommet a latch or a clip.

The collapsible reservoir 58 includes bellows 90. The bellows 90 enable the collapsible reservoir 58 to linearly collapse and expand along the racked and de-racked spaces. Furthermore, the bellows 90 can induce a suction effect upon expansion, such the collapsible reservoir 58 can draw in the dielectric immersion cooling liquid while expanding. The connecting part 104 is positioned such that the connecting part 104 (i.e. the fluid connection between the collapsible reservoir 58 and the rack-mounted immersion case 54) is below an expected level of the dielectric immersion cooling liquid when the rack-mounted immersion case 54 is de-racked, which can prevent air from entering the collapsible reservoir 58.

In some embodiments, the bellows 90 could be omitted. In such embodiments, the collapsible reservoir 58 could still expand and collapse along the racked and de-racked spaces. For instance, in some embodiments, the collapsible reservoir 58 could be made from a malleable material. The collapsible reservoir 58 may be made from plastic, though it is contemplated that other suitable material such as rubber or silicone could be used.

Still referring to Figures 1A, 1B, 2A and 2B, a description of the present technology as it is being used will now be provided. As each one of the rack-mounted immersion cases 54 and features connected thereto (i.e. the cable/tube bundle 56, the collapsible reservoir 58 and the articulating scissor structure 80) is similar to one another, the description will only refer to one rack-mounted immersion case 54 and the features connected thereto.

As shown in Figures 1A and 1B, the rack-mounted immersion case 54 is racked in the rack frame 52. The rack-mounted immersion case 54 contains the dielectric immersion cooling liquid therein, and the cable/tube bundle 56 is operatively connected to the electronic device 72 and the serpentine convection coil 74, both of which are received in the rack-mounted immersion case 54. The arm 82 of the articulating scissor structure 80 is connected to the backplane 70, and the arm 84 is connected to the backplane 62. A portion of the cable/tube bundle 56 extends along the articulating scissor structure 80. The collapsible reservoir 58 is fluidly connected to backplane 70 of the rack-mounted immersion case 54. The collapsible reservoir 58 is collapsed, and contains a small volume of the dielectric immersion cooling liquid.

Cold water, or another fluid, may be carried by one of the tubes of the cable/tube bundle 56, and supplied to cooling blocks (not shown) mounted on the electronic device 72 to cool the electronic device 72. Subsequently, the water, which has increased in temperature but is expected to still be cooler than the dielectric immersion cooling liquid, is supplied to the serpentine convection coil 74. As the water flows through the serpentine convection coil 74, heat transfer between the serpentine convection coil 74 and the dielectric immersion cooling liquid induces convection of the dielectric immersion cooling liquid within the rack-mounted immersion case 54. The water then exits the serpentine convection coil 74 through another one of the tubes of the cable/tube bundle 56. Mounting the serpentine convention coil 74 upstream of the electronic device 72 along the path of the supplied water is also contemplated.

Referring to Figures 2A and 2B, to access the electronic device 72, for instance to perform maintenance operations, the rack-mounted immersion case 54 can be slidingly de-racked.

While de-racking, the articulating scissor structure 80 laterally extends, and guides the cable/tube bundle 56 across the de-racked space. This enables the connections between the cable/tube bundle 56 and the rack-mounted immersion case 54 to not disconnect and to not tangle.

While de-racking, since the front portion 100 is fixedly connected to the backplane 70 and the rear portion 102 is fixedly connected to the backplane 62, the collapsible reservoir 58 expands along the de-racked spaced. When the collapsible reservoir 58 expands, a volume thereof increases. In response to the de-racking of the immersion case 70, some of the dielectric immersion cooling liquid flows from the immersion case 70 to the collapsible reservoir 58. This can occur because of hydrostatic pressure difference. In some embodiments, as mentioned above, due to the position of the connecting part 104 being lower than a level of the dielectric immersion cooling liquid in the de-racked position, some of the dielectric immersion cooling liquid can be drawn into the collapsible reservoir 58 by a suction effect resulting from the expansion of the collapsible reservoir 58.

As a result of some of the dielectric immersion cooling liquid flowing from rack-mounted immersion case 54 to the collapsible reservoir 58, access to the electrical device 72 is facilitated, as liquid level within the rack-mounted immersion case 54 is decreased. In addition, the decreased liquid level can reduce likelihood of dielectric immersion cooling liquid spilling from the rack-mounted immersion case 54 during the de-racking operation. Furthermore, sliding rack-mounted immersion case 54 also becomes easier as a weight thereof becomes smaller.

Then, referring back to Figures 1A and 1B, the rack-mounted immersion case 54 can be slidingly racked.

While racking, the articulating scissor structure 80 laterally contracts and guides the cable/tube bundle 56 within the racked space. This can help to reduce the chances of the cable/tube bundle 56 from tangling.

While racking, the articulating scissor structure 80 can engage the collapsible reservoir 58 to induce collapse of the collapsible reservoir 58. To this end, in some embodiments, the joining portion 86 of the articulating scissor structure 80 could be aligned with one of the bellows 90.

While racking, since the front portion 100 is fixedly connected to the backplane 70 and the rear portion 102 is fixedly connected to the backplane 62, the collapsible reservoir 58 collapses along the racked space. When the collapsible reservoir 58 collapses, the volume thereof decreases. In response to the racking of the rack-mounted immersion case 54, some of the dielectric immersion cooling liquid present in the collapsible reservoir 58 flows to the rack-mounted immersion case 54 through the connecting part 104. In some embodiments, this can occur because an ejection effect resulting from the collapse of the collapsible reservoir 58.

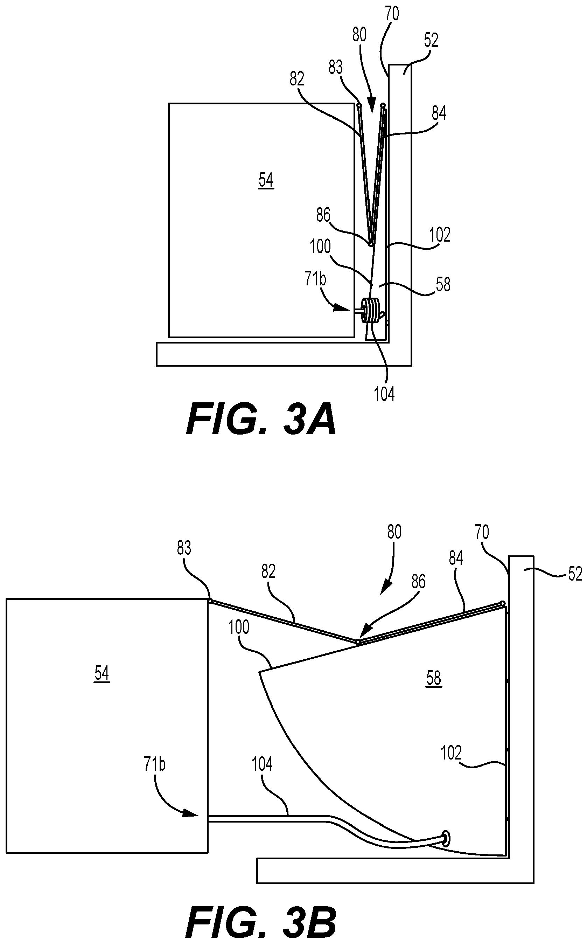

Referring now to Figures 3A and 3B a description of an alternate embodiment of the collapsible reservoir 58 will be provided. This embodiment is configured to connect to the rack-mounted immersion case 54 and to the rack frame 52 in a similar fashion to what is described above, and is configured to work similarly as well. Thus, this embodiment will only be briefly described.

The front portion 100 of the collapsible reservoir 58 is fixedly connected to the arm 84 of the articulating scissor structure 80, and the rear portion 100 of the collapsible reservoir 58 is directly connected to the backplane 70 of the rack frame 52. The collapsible reservoir 58 has the connecting part 104 that fluidly connects the collapsible reservoir 58 to the rack-mounted immersion case 54. The connecting part 104 is a fluid conduit, which can be bundled up (as shown in Figure 3A) when the rack-mounted immersion case 54 is in the racked position, and can be unbundled as the rack-mounted immersion case 54 is moved from the racked position to the de-racked position.

In this embodiment, while de-racking the rack-mounted immersion case 54, the articulating scissor structure 80 laterally extends, and guides the cable/tube bundle 56 across the de-racked space. As the collapsible reservoir 58 is connected to the arm 84, this results in the collapsible reservoir 58 expanding rotationally, as shown in Figure 3B.

Similarly, while racking the rack-mounted immersion case 54, the articulating scissor structure 80 laterally contracts and guides the cable/tube bundle 56 within the racked space. As the collapsible reservoir 58 is connected to the arm 84, this results in the collapsible reservoir 58 collapsing rotationally.

The foregoing description is intended to be exemplary rather than limiting. The scope of the present invention is intended to be limited solely by the appended claims

## Claims

1. A rack system (50) for housing at least one rack-mounted immersion case (54), comprising a rack frame (52) configured to allow slidable racking and slidable de-racking operations of the at least one rack-mounted immersion case (54) within the rack system (50),
**characterized in that**:
the rack system (50) further comprises at least one collapsible reservoir (58) fluidly connected to the at least one rack-mounted immersion case (54), the at least one collapsible reservoir (58) being configured to store a liquid and having a first portion (100, 104) connected to the at least one rack-mounted immersion case (54) below an expected level of liquid in the at least one rack-mounted immersion case (54) when the at least one rack-mounted immersion case (54) is in the de-racked position, and a second portion (102) fixedly connected to the rack frame (52), wherein:
the at least one collapsible reservoir (58) is configured to collapse along a racked spaced in response to a racking operation; and
the at least one collapsible reservoir is configured to expand along a de-racked space in response to a de-racking operation,
the racked and de-racked spaces being defined between a backplane (70) of the at least one rack-mounted immersion case (54) and a backplane (62) of the rack frame (52), in which the de-racked space is larger than the racked space.

2. The rack system (50) of claim 1, wherein:
the first portion (100) is fixedly connected to the backplane (70) of the at least one rack-mounted immersion case (54); and
the second portion (102) is fixedly connected to the backplane (62) of the rack frame (52).

3. The rack system (50) of claim 1 or 2, wherein the at least one rack-mounted immersion case (54) contains a liquid, and the at least one collapsible reservoir (58) is configured to expand to allow some of the liquid to flow from the at least one rack-mounted immersion case (54) to the at least one collapsible reservoir (58) in response to de-racking the at least one rack-mounted immersion case.

4. The rack system (50) of claim 3, wherein the at least one collapsible reservoir (58) is configured to collapse and allow some of the liquid to flow from the at least one collapsible reservoir (58) to the at least one rack-mounted immersion case (54) in response to racking the at least one rack-mounted immersion case (54).

5. The rack system (50) of any one of claims 1 to 4, wherein the at least one collapsible reservoir (58) includes bellows (90).

6. The rack system (50) of any one of claims 1 to 5, wherein the at least one collapsible reservoir (58) is configured to collapse linearly.

7. The rack system (50) of any one of claims 1 to 6, wherein the at least one collapsible reservoir (58) is made from plastic.

8. The rack system (50) of any one of claims 1 to 7, wherein the liquid is a dielectric immersion cooling liquid.

9. The rack system (50) of any one of claims 1 to 8, further comprising:
an opening (64) within the rack frame (52) configured to accommodate at least one cable/tube bundle (56), the at least one cable/tube bundle (56) servicing the at least one rack-mounted immersion case (54) within the rack system (52);
at least one articulating scissor structure (80) comprising:
a first arm (82) detachably connected to a contact point (83) on the backplane (70) of the at least one rack-mounted immersion case (54),
a second arm (84) detachably connected to a contact point (85) on the backplane (62) of the rack frame (52), and
a joining portion (86) connecting the first and second arms (82, 84);
the at least one articulating scissor structure (80) configured to guide the at least one cable/tube bundle (56) along the racked space and the de-racked space, wherein,
the at least one articulating scissor structure (80) is configured to laterally extend and guide the at least one cable/tube bundle (56) across the de-racked space during the de-racking operation of the at least one rack-mounted immersion case (54), and
the at least one articulating scissor structure (80) is configured to laterally contract and guide the cable/tube bundle (56) within the racked space during the racking operation of the at least one rack-mounted immersion case (54).

10. The rack system (50) of claim 9, wherein:
the at least one articulating scissor structure (80) is configured to engage the at least one collapsible reservoir (58) to induce collapse of the collapsible reservoir (58) during the de-racking operation of the at least one rack-mounted immersion case (54).

11. The rack system (50) of any one of claims 1 to 10, wherein the at least one rack-mounted immersion case (54) comprises a plurality of rack-mounted immersion cases (54).

12. The rack system (50) of any one of claims 1 to 11, wherein the at least one collapsible reservoir (58) comprises a plurality of collapsible reservoirs (58).

## Patentansprüche

1. Racksystem (50) zur Aufnahme mindestens eines Einschubtauchgehäuses (54), umfassend einen Rackrahmen (52), der zum Ermöglichen gleitender Einschiebe- und Ausziehvorgänge des mindestens einen Einschubtauchgehäuses (54) innerhalb des Racksystems (50) konfiguriert ist,
**dadurch gekennzeichnet, dass**
das Racksystem (50) ferner mindestens einen faltbaren Behälter (58) umfasst, der fluidisch mit dem mindestens einen Einschubtauchgehäuse (54) verbunden ist, wobei der mindestens eine faltbare Behälter (58) zum Speichern einer Flüssigkeit konfiguriert ist und einen ersten Abschnitt (100, 104), der mit dem mindestens einen Einschubtauchgehäuse (54) unterhalb eines erwarteten Flüssigkeitspegels in dem mindestens einen Einschubtauchgehäuse (54) verbunden ist, wenn sich das mindestens eine Einschubtauchgehäuse (54) in der herausgezogenen Position befindet, und einen zweiten Abschnitt (102) aufweist, der fest mit dem Rackrahmen (52) verbunden ist, wobei:
der mindestens eine faltbare Behälter (58) als Reaktion auf einen Einschiebevorgang zum Falten entlang eines Einschieberaums konfiguriert ist; und
der mindestens eine faltbare Behälter als Reaktion auf einen Ausziehvorgang zum Expandieren entlang eines Ausziehraums konfiguriert ist,
wobei der Einschiebe- und Ausziehraum zwischen einer Rückwand (70) des mindestens einen Einschubtauchgehäuses (54) und einer Rückwand (62) des Rackrahmens (52) definiert sind, wobei der Ausziehraum größer als der Einschieberaum ist.

2. Racksystem (50) nach Anspruch 1, wobei:
der erste Abschnitt (100) fest mit der Rückwand (70) des mindestens einen Einschubtauchgehäuses (54) verbunden ist; und der zweite Abschnitt (102) fest mit der Rückwand (62) des Rackrahmens (52) verbunden ist.

3. Racksystem (50) nach Anspruch 1 oder 2, wobei das mindestens eine Einschubtauchgehäuse (54) eine Flüssigkeit enthält und der mindestens eine faltbare Behälter (58) als Reaktion auf ein Ausziehen des mindestens einen Einschubtauchgehäuses zum Expandieren konfiguriert ist, um zu ermöglichen, dass ein Teil der Flüssigkeit von dem mindestens einen Einschubtauchgehäuse (54) zu dem mindestens einen faltbaren Behälter (58) fließt.

4. Racksystem (50) nach Anspruch 3, wobei der mindestens eine faltbare Behälter (58) als Reaktion auf ein Einschieben des mindestens einen Einschubtauchgehäuses (54) zum Falten und Ermöglichen konfiguriert ist, dass ein Teil der Flüssigkeit von dem mindestens einen faltbaren Behälter (58) zu dem mindestens einen Einschubtauchgehäuse (54) fließt.

5. Racksystem (50) nach einem der Ansprüche 1 bis 4, wobei der mindestens eine faltbare Behälter (58) einen Faltenbalg (90) umfasst.

6. Racksystem (50) nach einem der Ansprüche 1 bis 5, wobei der mindestens eine faltbare Behälter (58) zum linearen Falten konfiguriert ist.

7. Racksystem (50) nach einem der Ansprüche 1 bis 6, wobei der mindestens eine faltbare Behälter (58) aus Kunststoff hergestellt ist.

8. Racksystem (50) nach einem der Ansprüche 1 bis 7, wobei die Flüssigkeit eine dielektrische Immersionskühlflüssigkeit ist.

9. Racksystem (50) nach einem der Ansprüche 1 bis 8, ferner umfassend:
eine Öffnung (64) innerhalb des Rackrahmens (52), die zum Aufnehmen mindestens eines Kabel-/Rohrbündels (56) konfiguriert ist, wobei das mindestens eine Kabel-/Rohrbündel (56) das mindestens eine Einschubtauchgehäuse (54) innerhalb des Racksystems (52) versorgt;
mindestens eine gelenkige Scherenstruktur (80), umfassend:
einen ersten Arm (82), der lösbar mit einer Kontaktstelle (83) an der Rückwand (70) des mindestens einen Einschubtauchgehäuses (54) verbunden ist,
einen zweiten Arm (84), der lösbar mit einer Kontaktstelle (85) an der Rückwand (62) des Rackrahmens (52) verbunden ist, und
einen Verbindungsabschnitt (86), der den ersten und den zweiten Arm (82, 84) verbindet;
wobei die mindestens eine gelenkige Scherenstruktur (80) zum Führen des mindestens einen Kabel-/Rohrbündels (56) entlang des Einschieberaums und des Ausziehraums konfiguriert ist, wobei die mindestens eine gelenkige Scherenstruktur (80) zum seitlichen Verlängern und Führen des mindestens einen Kabel-/Rohrbündels (56) durch den Ausziehraum während des Ausziehvorgangs des mindestens einen Einschubtauchgehäuses (54) konfiguriert ist, und
die mindestens eine gelenkige Scherenstruktur (80) zum seitlichen Zusammenziehen und Führen des Kabel-/Rohrbündels (56) innerhalb des Einschieberaums während des Einschiebevorgangs des mindestens einen Einschubtauchgehäuses (54) konfiguriert ist.

10. Racksystem (50) nach Anspruch 9, wobei:
die mindestens eine gelenkige Scherenstruktur (80) zum Eingreifen in den mindestens einen faltbaren Behälter (58) konfiguriert ist, um ein Falten des faltbaren Behälters (58) während des Ausziehvorgangs des mindestens einen Einschubtauchgehäuses (54) einzuleiten.

11. Racksystem (50) nach einem der Ansprüche 1 bis 10, wobei das mindestens eine Einschubtauchgehäuse (54) eine Vielzahl von Einschubtauchgehäusen (54) umfasst.

12. Racksystem (50) nach einem der Ansprüche 1 bis 11, wobei der mindestens eine faltbare Behälter (58) eine Vielzahl von faltbaren Behältern (58) umfasst.

## Revendications

1. Système de crémaillère (50) pour accueillir au moins un boîtier d'immersion monté en crémaillère (54), comprenant un cadre de crémaillère (52) configuré pour permettre des opérations de rackage coulissant et de dérackage coulissant de l'au moins un boîtier d'immersion monté en crémaillère (54) à l'intérieur du système de crémaillère (50),
**caractérisé en ce que** :
le système de crémaillère (50) comprend en outre au moins un réservoir repliable (58) connecté fluidiquement à l'au moins un boîtier d'immersion monté en crémaillère (54), l'au moins un réservoir repliable (58) étant configuré pour stocker un liquide et ayant une première partie (100, 104) connectée à l'au moins un boîtier d'immersion monté en crémaillère (54) en dessous d'un niveau attendu de liquide dans l'au moins un boîtier d'immersion monté en crémaillère (54) lorsque l'au moins un boîtier d'immersion monté en crémaillère (54) est dans la position dérackée, et une seconde partie (102) connectée de manière fixe au cadre de crémaillère (52), dans lequel :
l'au moins un réservoir repliable (58) est configuré pour se replier le long d'un espace racké en réponse à une opération de crémaillère ; et
l'au moins un réservoir repliable est configuré pour s'étendre le long d'un espace déracké en réponse à une opération de dérackage,
les espaces rackés et dérackés étant définis entre un fond de panier (70) de l'au moins un boîtier d'immersion monté en crémaillère (54) et un fond de panier (62) du cadre de crémaillère (52), dans lequel l'espace déracké est plus grand que l'espace racké.

2. Système de crémaillère (50) selon la revendication 1, dans lequel :
la première partie (100) est connectée de manière fixe au fond de panier (70) de l'au moins un boîtier d'immersion monté en crémaillère (54) ; et
la seconde partie (102) est connectée de manière fixe au fond de panier (62) du cadre de crémaillère (52).

3. Système de crémaillère (50) selon la revendication 1 ou 2, dans lequel l'au moins un boîtier d'immersion monté en crémaillère (54) contient un liquide, et l'au moins un réservoir repliable (58) est configuré pour s'étendre pour permettre à une partie du liquide de s'écouler de l'au moins un boîtier d'immersion monté en crémaillère (54) vers l'au moins un réservoir repliable (58) en réponse au dérackage de l'au moins un boîtier d'immersion monté en crémaillère.

4. Système de crémaillère (50) selon la revendication 3, dans lequel l'au moins un moins un réservoir repliable (58) est configuré pour se replier et permettre à une partie du liquide de s'écouler de l'au moins un réservoir repliable (58) vers l'au moins un boîtier d'immersion monté en crémaillère (54) en réponse au rackage de l'au moins un boîtier d'immersion monté en crémaillère (54).

5. Système de crémaillère (50) selon l'une quelconque des revendications 1 à 4, dans lequel l'au moins un réservoir repliable (58) comporte des soufflets (90).

6. Système de crémaillère (50) selon l'une quelconque des revendications 1 à 5, dans lequel l'au moins un réservoir repliable (58) est configuré pour se replier linéairement.

7. Système de crémaillère (50) selon l'une quelconque des revendications 1 à 6, dans lequel l'au moins un réservoir repliable (58) est en matière plastique.

8. Système de crémaillère (50) selon l'une quelconque des revendications 1 à 7, dans lequel le liquide est un liquide diélectrique de refroidissement par immersion.

9. Système de crémaillère (50) selon l'une quelconque des revendications 1 à 8, comprenant en outre :
une ouverture (64) à l'intérieur du cadre de crémaillère (52) configurée pour recevoir au moins un faisceau de câbles/tubes (56), l'au moins un faisceau de câbles/tubes (56) desservant l'au moins un boîtier d'immersion monté en crémaillère (54) à l'intérieur du système de crémaillère (52) ;
au moins une structure de ciseaux articulés (80) comprenant :
un premier bras (82) connecté de manière amovible à un point de contact (83) sur le fond de panier (70) de l'au moins un boîtier d'immersion monté en crémaillère (54),
un second bras (84) connecté de manière amovible à un point de contact (85) sur le fond de panier (62) du cadre de crémaillère (52), et
une partie de jonction (86) connectant les premier et second bras (82, 84) ;
l'au moins une structure de ciseaux articulés (80) étant configurée pour guider l'au moins un faisceau de câbles/tubes (56) le long de l'espace racké et de l'espace déracké, dans lequel,
l'au moins une structure de ciseaux articulés (80) est configurée pour étendre et guider latéralement l'au moins un faisceau de câbles/tubes (56) à travers l'espace racké lors de l'opération de dérackage de l'au moins un boîtier d'immersion monté en crémaillère (54), et
l'au moins une structure de ciseaux articulés (80) est configurée pour contracter et guider latéralement le faisceau de câbles/tubes (56) à l'intérieur de l'espace racké lors de l'opération de rackage de l'au moins un boîtier d'immersion monté en crémaillère (54).

10. Système de crémaillère (50) selon la revendication 9, dans lequel :
l'au moins une structures de ciseaux articulés (80) est configurée pour venir en prise avec l'au moins un réservoir repliable (58) pour induire un repli du réservoir repliable (58) lors de l'opération de dérackage de l'au moins un boîtier d'immersion monté en crémaillère (54).

11. Système de crémaillère (50) selon l'une quelconque des revendications 1 à 10, dans lequel l'au moins un boîtier d'immersion monté en crémaillère (54) comprend une pluralité de boîtiers d'immersion montés en crémaillère (54).

12. Système de crémaillère (50) selon l'une quelconque des revendications 1 à 11, dans lequel l'au moins un réservoir repliable (58) comprend une pluralité de réservoirs repliables (58) .
